# EUROPEAN PATENT SPECIFICATION

(11) **EP 2 025 007 B1**
(45) Date of publication and mention of the grant of the patent: **31.10.2018**
(21) Application number: 07747321.3
(22) Date of filing: 01.06.2007
(51) Int. Cl.: H01L 31/18, H01L 31/048, E04D 13/18

(54) **COLD-CURVED SOLAR PANEL**
KALTGEKRÜMMTES SOLAR-PANEL
PANNEAU SOLAIRE COURBÉ À FROID

(30) Priority: 02.06.2006 NL 1031941
(43) Date of publication of application: 18.02.2009
(73) Proprietor: Movares Nederland B.V., 3511 SX Utrecht (NL)
(72) Inventor: VÁKÁR, László, Imre, NL-3818 JB Amersfoort (NL)
(74) Representative: Vernout, Robert
(86) International application number: PCT/NL2007/000139
(87) International publication number: WO 2007/142515

(56) References cited:
- WO-A-2006/015430
- CH-A5- 683 730
- DE-A1- 19 630 813
- DE-C1- 10 218 198
- JP-A- 3 204 979
- JP-A- 2004 300 865

## Description

The present invention provides a method for curving a solar panel, and such a solar panel. WO 2006/015430 discloses solar cells which are mounted on a flexible substrate, which flexible substrate is mounted on a curved rigid surface.

In the past decade the use of curved forms in architecture has greatly increased. In addition, much use is made of glass to allow more sunlight into the living and working environment of people. As well as the quality of the living and working environment, the durability of this environment is also an important factor nowadays, and there is increasing focus on environmentally-friendly energy sources such as solar energy. These aspects are increasingly being combined in building projects, whereby there is an increasing demand for curved solar panels which for instance form part of a curved glass facade or glass roof.

The manufacture of curved solar panels is at this time limited to hot-curving of the panels. Due to the high temperature necessary for the curving, this curving is not possible at the location where the panels are ultimately mounted in a support structure, and the panels must be supplied by the producer in pre-curved form. This entails the panels having to be transported in curved state from the producer to the construction site.

A drawback of hot-curved solar panels is that they have to be transported in the curved state, which results in inefficient use of space in means of transport and in the case of interim storage.

An additional drawback is that hot-curved solar panels are pre-curved and may have variations in curving radius, which sometimes results in a poor connection of the panels to the eventual support structure. It is also less readily possible to anticipate varying tolerances occurring in the building construction.

A further drawback is that a solar panel curved in the known manner cannot easily withstand movements in the building construction, for instance as a result of wind load.

The object of the present invention is to provide a method and solar panel in which at least one of the drawbacks associated with the prior art is obviated.

According to the invention a method according to claim 1 and a solar panel according to claim 3 is provided.

The present invention makes it possible to transport solar panels from a production location to a construction site in non-curved position, and to then bend the solar panels into the desired curved form at the construction site and fit them on, on top of or against a building. Because the solar panels are still in non-curved position during transport or interim storage, the advantage is gained of this transport and this storage becoming relatively simple, and therefore cheaper and more efficient, while providing architects the option of incorporating the solar panels in curved walls or roofs of buildings. Because the solar panels can furthermore be curved in "cold" state, they can bend so as to follow the surface or building construction in which the panels are mounted.

The glass can be thermally or chemically tempered. In the embodiment wherein the photovoltaic elements are formed in a film of semiconductor material formed on the plate, chemically tempered glass is recommended in respect of the high temperatures required to form the photovoltaic elements.

In a further embodiment the assembly is placed on a curved support structure, whereafter the assembly is curved by pressing parts of the peripheral edge against the curved support structure and fixing the assembly in curved position.

In another further embodiment the assembly is curved by clamping a part of the peripheral edge and then displacing at least a subsequent part of the peripheral edge such that the assembly bends.

In yet another further embodiment use is made of a pre-formed mould in curving of the assembly.

The method preferably comprises of fastening one or more holding elements to the solar panel for fixing thereof in the curved state. The holding elements can herein be adapted to provide a number of fastening points or a discontinuous fastening between the one or more holding elements and the solar panel, such as for instance when a holding element is formed by at least one cable or rod. In this embodiment of the present invention the solar panel is held in the curved position by mutually connecting mutually opposite parts of the peripheral edge by means of one or more cables or rods, whereby the bending stress in the assembly is absorbed by a tension in the cables or rods. In another embodiment the assembly is held in the curved position by one or more holding elements which protrude through holes in the plate. The holding elements can however also be adapted to provide linear fastenings between the one or more holding elements and the solar panel, for instance by fixedly clamping the curved solar panel along mutually opposite end edges.

In yet another embodiment the assembly comprises at least two plates of glass, between which spacers are arranged such that the plates of glass and spacers define a space insulated from the environment.

In another embodiment the photovoltaic elements are of the crystalline type.

In yet another embodiment the photovoltaic elements are of the amorphous type.

Further advantages, features and details of the present invention in general are further elucidated hereinbelow on the basis of a description of a preferred embodiment, with reference to the accompanying drawings, in which:
figure 1 shows a perspective view of a support structure with a curved support frame for curving a solar panel in accordance with an embodiment of the present invention and fastening the curved solar panel to the support frame;
figure 2 shows the same view as figure 1, wherein the solar panel, not yet curved, rests on the support frame;
figure 3 shows the same view as figures 1 and 2, wherein in accordance with an embodiment of the invention the solar panel is curved into desired form on the support frame and is held fast using glazing bars;
figure 4 shows an exploded detail view of an assembly according to a preferred embodiment of the present invention;
figure 5 shows an exploded detail view of an alternative embodiment of the assembly according to the present invention;
figure 6 shows an exploded detail view of a further alternative embodiment of an assembly according to the present invention;
figure 7 shows an exploded detail view of an alternative embodiment of an assembly according to the present invention.

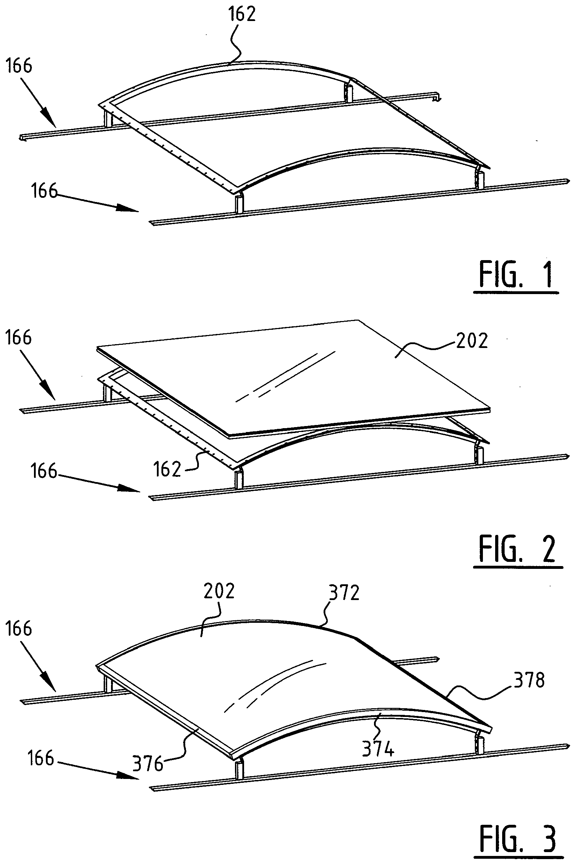

Figure 1 shows a support structure 166 to which is fixed a support frame 162. Solar panel 202 is placed on support frame 162 (see figure 2). The sides of solar panel 202 are then pressed against support frame 162, whereby solar panel 202 bends. In figure 3 the solar panel 202 under bending stress is then fixed to support frame 162 in the curved position. In the shown preferred embodiment solar panel 202 is fixed to support frame 162 on the sides using glazing bars 372, 374, 376, 378, so that a linear connection between the solar panel and the support frame is provided. It is however also possible to fasten the solar panel to one or more supports? at a number of discrete positions for the purpose of providing fastening points between the solar panel and the respective supports.

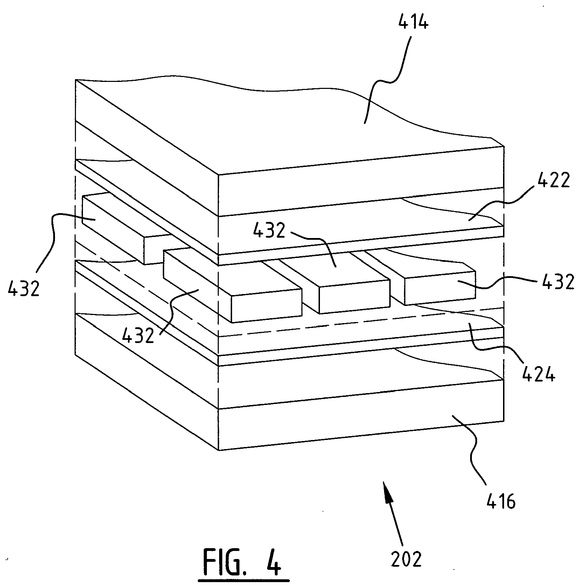

A preferred embodiment of solar panel 202 according to the invention comprises (figure 4) at least two layers of glass 414, 416 between which are arranged photovoltaic elements 432, between which layers of glass 414, 416 and photovoltaic elements 432 are arranged adhesive layers 422, 424.

In a preferred embodiment photovoltaic elements 432 are of the crystalline type. In another embodiment the photovoltaic elements 432 are of the amorphous type and are for instance embodied in the form of a foil.

When this assembly of glass layers 414, 416 and photovoltaic elements 432 is curved at ambient temperature (typically between 5 and 50 degrees Celsius), glass layers 414, 416 and adhesive layers 422, 424 will actually bend, but the rigid photovoltaic elements 432 (if they are of the crystalline type) will not bend. A small space will hereby result between glass layers 414, 416 and photovoltaic elements 432. Adhesive layers 422, 424 must be sufficiently flexible to fill the thus created spaces, or must have sufficiently strong adhesive power to adhere the glass layers 414, 416 at the contact points to photovoltaic elements 432. A slight displacement will moreover occur between glass layers 414, 416 and photovoltaic elements 432 during the curving. Adhesive layers 422, 424 must be sufficiently flexible or allow sufficient creep to absorb this displacement.

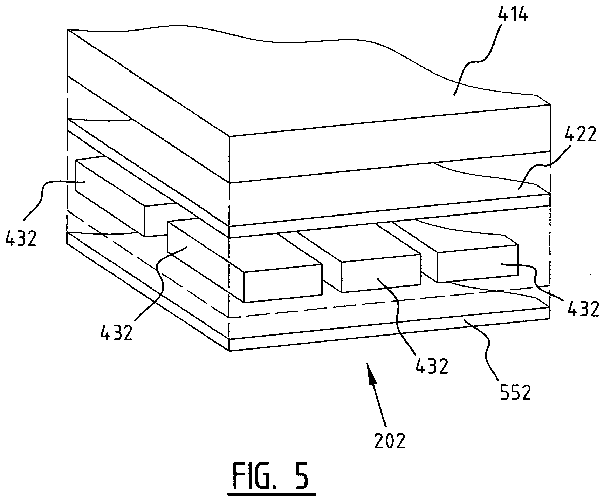

Figure 5 shows an alternative embodiment comprising a glass layer 414 and photovoltaic elements 432 placed in one plane, which photovoltaic elements 432 are arranged on glass layer 414 by means of an adhesive layer 422. A protective layer 552 is arranged in order to protect photovoltaic elements 432.

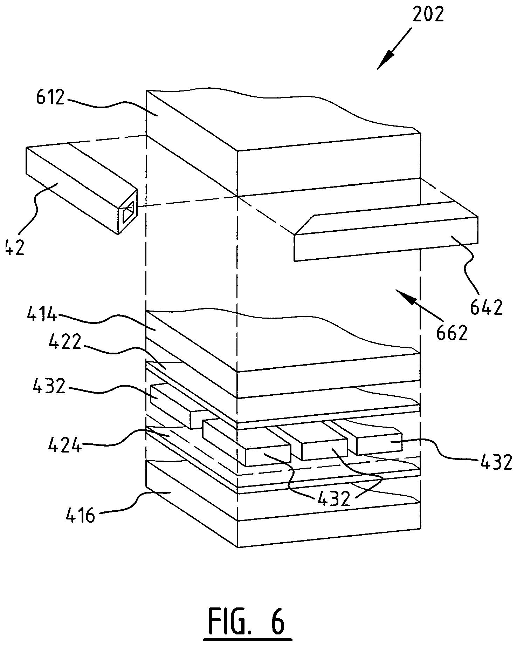

In a further alternative embodiment (figure 6) photovoltaic elements 432 are placed between at least two layers of glass 414, 416 in accordance with a preferred embodiment, between which photovoltaic elements 432 and glass layers 414, 416 are arranged adhesive layers 422, 424. At least one additional plate of glass 612 is arranged and spacers 642 are placed between plate of glass 612 and the inner glass layer 414, which plate of glass 612, glass layer 414 and spacers 642 define a space 662 insulated from the environment. Spacers 642 are of a form and composition such that they absorb the shear stresses created as a result of the curving.

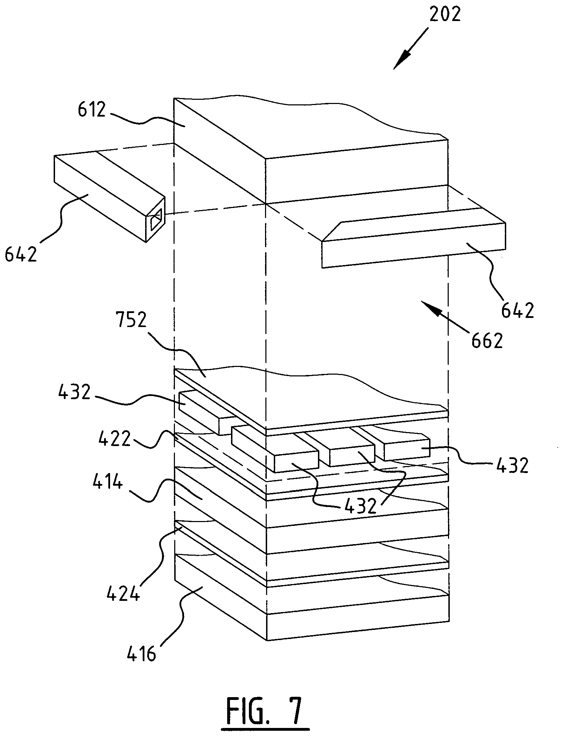

Figure 7 shows yet another embodiment of the invention. In this embodiment the assembly comprises at least two plates with a cavity 662 therebetween, wherein a first plate consists of at least two glass layers 414, 416, between which an adhesive layer 424 is arranged. On this first plate an adhesive layer 422 is arranged on the side of cavity 662, on which adhesive layer 422 are situated photovoltaic elements 432. Situated between photovoltaic elements 432 and cavity 662 is a protective layer 752. Spacers 642 are placed between protective layer 752 and second plate 612 in a manner such that a space 662 insulated from the environment is defined between protective layer 752, second plate 612 and spacers 642. Spacers 642 are sufficiently flexible and/or allow sufficient creep for the shear stresses resulting from the curving to be absorbed.

The present invention is not limited to the above stated preferred embodiment thereof; the rights sought are defined by the scope of the following claims.

## Claims

1. Method for curving a solar panel (202), comprising:
- providing a solar panel (202) comprising at least one substantially flat plate of glass consisting of two or more layers (414, 416) of glass, wherein said glass is thermally or chemically tempered or semi-tempered glass, wherein one or more adhesive layers (422, 424) are arranged between the layers (414, 416), and photovoltaic elements (432) located in one plane arranged in or between the adhesive layers (422, 424) between the layers (414, 416) of glass;
- curving the solar panel (202) at ambient temperature; and
- fixing the solar panel (202) in the curved position while under bending stress.

2. Method as claimed in claim 1, wherein the solar panel (202) comprises at least two of said plates and spacers (642) are arranged between the at least two plates such that these plates and the spacers (642) define a space (662) insulated from the environment.

3. Solar panel (202), comprising:
- at least one plate of glass consisting of two or more layers (414, 416) of glass, wherein said glass is thermally or chemically tempered or semi-tempered glass,
wherein one or more adhesive layers (422, 424) are arranged between the layers
- at least one photovoltaic element (432) placed in a plane and arranged in or between the adhesive layers (422, 424) between the layers (414, 416) of glass, and
- at least one holding element (162) which is fastened to the plate and which is adapted to fixedly hold the plate with photovoltaic elements under bending stress in the curved position.

4. Solar panel as claimed in claim 3, wherein the photovoltaic elements (432) are of the crystalline type.

5. Solar panel as claimed in claim 3, wherein the photovoltaic elements (432) are of the amorphous type.

6. Solar panel as claimed in claim 3, 4 or 5, wherein the solar panel (202) comprises at least two of said plates and spacers (642) are arranged between the at least two plates such that these plates and the spacers (642) define a space (662) insulated from the environment.

## Patentansprüche

1. Verfahren zum Biegen eines Solarpanels (202), umfassend:
- Bereitstellen eines Solarpanels (202), welches wenigstens eine im Wesentlichen flache Glasplatte, die aus zwei oder mehr Glasschichten (414, 416) besteht, wobei das Glas thermisch oder chemisch vorgespanntes oder teilvorgespanntes Glas ist, wobei eine oder mehrere Haftschichten (422, 424) zwischen den Schichten (414, 416) angeordnet sind, und photovoltaische Elemente (432) umfasst, die in einer Ebene in oder zwischen den Haftschichten (422, 424) zwischen den Glasschichten (414, 416) angeordnet sind;
- Biegen des Solarpanels (202) bei Umgebungstemperatur; und
- Fixieren des Solarpanels (202) in der gebogenen Position, während es unter Biegebeanspruchung ist.

2. Verfahren nach Anspruch 1, wobei das Solarpanel (202) wenigstens zwei der Platten umfasst und Abstandshalter (642) zwischen den wenigstens zwei Platten so angeordnet sind, dass diese Platten und die Abstandshalter (642) einen von der Umgebung isolierten Raum (662) definieren.

3. Solarpanel (202), bestehend aus:
- wenigstens einer Glasplatte, die aus zwei oder mehr Glasschichten (414, 416) besteht, wobei das Glas thermisch oder chemisch vorgespanntes oder teilvorgespanntes Glas ist, wobei eine oder mehrere Haftschichten (422, 424) zwischen den Schichten angeordnet sind,
- wenigstens ein photovoltaisches Element (432), das in einer Ebene platziert und in oder zwischen den Haftschichten (422, 424) zwischen den Glasschichten (414, 416) angeordnet ist, und
- wenigstens ein Halteelement (162), das an der Platte befestigt ist und das dazu ausgelegt ist, die Platte mit photovoltaischen Elementen, während sie unter Biegebeanspruchung ist, in der gebogenen Position fixiert zu halten.

4. Solarpanel nach Anspruch 3, wobei die photovoltaischen Elemente (432) von der kristallinen Art sind.

5. Solarpanel nach Anspruch 3, wobei die photovoltaischen Elemente (432) von der amorphen Art sind.

6. Solarpanel nach Anspruch 3, 4 oder 5, wobei das Solarpanel (202) wenigstens zwei der Platten umfasst und Abstandshalter (642) zwischen den wenigstens zwei Platten derart angeordnet sind, dass diese Platten und die Abstandshalter (642) einen von der Umgebung isolierten Raum (662) definieren.

## Revendications

1. Procédé pour courber un panneau solaire (202), comprenant :
- la fourniture d'un panneau solaire (202) comprenant au moins une plaque de verre sensiblement plate constituée de deux ou plus de deux couches (414, 416) de verre, dans lequel ledit verre est un verre thermiquement ou chimiquement trempé ou semi-trempé, dans lequel une ou plusieurs couches d'adhésif (422, 424) sont agencées entre les couches (414, 416), et des éléments photovoltaïques (432) situés dans un plan agencé dans ou entre les couches d'adhésif (422, 424) entre les couches (414, 416) de verre ;
- la courbure du panneau solaire (202) à température ambiante ; et
- la fixation du panneau solaire (202) dans la position courbée tout en étant sous une contrainte de flexion.

2. Procédé selon la revendication 1, dans lequel le panneau solaire (202) comprend au moins deux desdites plaques et des entretoises (642) sont agencées entre les au moins deux plaques de façon que ces plaques et les entretoises (642) définissent un espace (662) isolé par rapport à l'environnement.

3. Panneau solaire (202), comprenant :
- au moins une plaque de verre constituée de deux ou plus de deux couches (414, 416) de verre, dans lequel ledit verre est un verre thermiquement ou chimiquement trempé ou semi-trempé,
dans lequel une ou plusieurs couches d'adhésif (422, 424) sont agencées entre les couches
- au moins un élément photovoltaïque (432) placé dans un plan et agencé dans ou entre les couches d'adhésif (422, 424) entre les couches (414, 416) de verre, et
- au moins un élément de maintien (162) qui est fixé à la plaque et qui est adapté pour maintenir de manière fixe la plaque avec les éléments photovoltaïques sous une contrainte de flexion dans la position courbée

4. Panneau solaire selon la revendication 3, dans lequel les éléments photovoltaïques (432) sont du type cristallin.

5. Panneau solaire selon la revendication 3, dans lequel les éléments photovoltaïques (432) sont du type amorphe.

6. Panneau solaire selon la revendication 3, 4 ou 5, dans lequel le panneau solaire (202) comprend au moins deux desdites plaques et des entretoises (642) sont agencées entre les au moins deux plaques de façon que ces plaques et les entretoises (642) définissent un espace (662) isolé par rapport à l'environnement.
